# EUROPÄISCHE PATENTANMELDUNG

(11) **EP 4 611 034 A1**
(43) Veröffentlichungstag der Anmeldung: **03.09.2025**
(21) Anmeldenummer: 24160522.9
(22) Anmeldetag: 29.02.2024
(51) Int. Cl.: H01L 23/473

(54) **MODULARER KÜHLKÖRPER MIT RAUMFÜLLENDER KÜHLKANALSTRUKTUR**

(71) Anmelder: Innomotics GmbH, 90441 Nürnberg (DE)
(72) Erfinder: Hermann, Christian, 91126 Schwabach (DE); Lubosch, Maik, 90425 Nürnberg (DE); Schaller, Stefan, 91459 Markt Erlbach (DE); Stoyanov, Stefan, 92342 Freystadt (DE)
(74) Vertreter: Siemens Patent Attorneys

(57) **Zusammenfassung**

Die Erfindung betrifft einen modular aufgebauten Kühlkörper, insbesondere Flüssigkeits-Kühlkörper (1) eines Leistungshalbleiters (10),
wobei der Flüssigkeits-Kühlkörper (1) zumindest einen Einlass (2) und einen Auslass (3) in einem Gehäuse (4) aufweist, das den Flüssigkeits-Kühlkörper (1) umgibt und an den die Leistungshalbleiter (10) zumindest auf einer Seite des Gehäuses (4) thermisch direkt gekoppelt sind,
wobei eine offene Kanalstruktur (11) in einem wärmeleitenden Material vorgesehen ist, das durch einen Deckel des Gehäuses (4) geschlossen ist,
wobei die Kanalstruktur (11) des Flüssigkeits-Kühlkörpers (1) ist als eine modifizierte raumfüllende Kurve ausgeführt.

## Beschreibung

Die Erfindung betrifft einen modular aufgebauten Flüssigkeits-Kühlkörper und einen Umrichter mit einem derartigen Flüssigkeits-Kühlkörper.

Die bisher bei Leistungshalbleitern eingesetzten Kühlkörper weisen entweder einen zu geringen Druckabfall mit mangelnder Kühleffizienz oder eine ungleichmäßige Kühlung auf der zu kühlenden Fläche auf.

Es wurde somit immer ein unbefriedigender Kompromiss zwischen Gleichmäßigkeit der Kühlung und Druckabfall des Kühlkörpers eingegangen. Die thermische Performance des Gesamtkühlkörpers resultierte aus der thermischen Performance der am schlechtesten gekühlten Komponente. Diese führt zu einer niedrigeren Effektivität der Kühlung.

Eine Erhöhung des Druckabfalls wurde bis jetzt entweder durch Verengung des Kühlkanalquerschnitts und Erhöhung der Kühlkanallänge oder durch Verengung im Bereich von Zu- und Rücklauf durch Blenden erreicht.

Eine gleichmäßigere Kühlung von mehreren Komponenten, erreicht durch parallel verzweigte Kühlkreise und parallele Kühlung der Komponenten, erzeugt jedoch einen geringeren Druckabfall.

Unterschiedlich ist die Art, wie der Druckabfall erzeugt wird. Die bekannten Lösungen erzeugen den Druckabfall durch eine hohe Fließgeschwindigkeit des Kühlmediums im Kühlkanal des Kühlkörpers, was durch eine Kanalverengung / hohe Kanallänge oder durch Verengungen von Zu- und Rücklauf des Kühlkörpers realisiert werden kann.

Umgekehrt führt ein erhöhter Druckabfall, erreicht durch verengte und längere Kühlkanäle und serielle Kühlung der Komponenten, zu einer ungleichmäßigeren Kühlung der Gesamtkühloberfläche.

Der Druckabfall resultiert primär durch Erhöhung der Geschwindigkeit des Kühlmediums, die durch einen Kühlkanal mit einem zu engen Querschnitt zustande kommt. Die Kühlkanäle weisen deshalb entweder lange Strecken auf oder das Kühlfluid wird spiralförmig bewegt. Folglich wird die Sensitivität des Kühlkörpers auf Druckabfallschwankungen und zusätzlich durch Fertigungsschwankungen erhöht.

Ausgehend davon liegt der Erfindung die Aufgabe zugrunde einen Flüssigkeits-Kühlkörper bereitzustellen, der u.a. die oben genannten Nachteile vermeidet und eine effiziente Kühlung, insbesondere von Leistungshalbleitern eines elektrischen Antriebs, gewährleistet.

Die Lösung der gestellten Aufgabe gelingt durch eine Merkmalskombination der unabhängigen Ansprüche.

Vorteilhafte Ausgestaltungen sind den abhängigen Ansprüchen zu entnehmen.

Es wurde ein modular aufgebauter Kühlkörper, insbesondere ein Flüssigkeits-Kühlkörper geschaffen, bei dem die Kanalform in ihrer Länge modular aufgebaut ist. Ein Modul wurde als eine modifizierte raumfüllende Kurve geschaffen, wie sie z. B. als Hilbert- oder Peano-Kurven vorliegen. Dadurch ist es möglich, mit einer Anordnung von dementsprechenden ähnlichen, insbesondere identischen Kühlkanal-Modulen eine beliebige Fläche, z.B. die Kühlkörperfläche, nahezu vollständig auszufüllen und damit thermisch zu optimieren.

Es liegt erfindungsgemäß nunmehr ein modular aufgebauter Kühlkörper, insbesondere Flüssigkeits-Kühlkörper mit raumfüllender Kanalstruktur, insbesondere in einer Ebene vor.

Als Kühlmedien sind dabei Gase, wie z.B. Luft denkbar, aber vor allem Flüssigkeiten, wie z.B. Wasser.

Dieser Kühlkörper weist einen vergleichsweise höheren oder angepassten Druckabfall auf. Dies führt zu einer gleichmäßigen Kühlleistung des Kühlkörpers, so dass eine ausreichende gleichmäßige thermische Performance des Kühlkörpers vorliegt.

Es kann somit auf eine Überdimensionierung des Kühlkörpers verzichtet werden, da alle an diesen Kühlkörper thermisch gekoppelten Komponenten vergleichbar gut und gleichmäßig gekühlt werden.

Dabei wird nunmehr ein Druckabfall im Kühlkörper durch Umlenkung der Fließrichtung des Kühlmediums erzeugt, die eine zusätzliche Durchmischung der Fluidschichten bewirkt, was zu einer turbulenten Grenzschicht führt. Dies führt erfindungsgemäß zu einer höheren Wärmeübergangszahl zwischen Kühlkörper und der zu kühlenden Komponente und damit zu einer vergleichsweise besseren thermischen Performance des gesamten Kühlsystems.

Der Kühlkanal kann so gestaltet werden, dass die Fluidgeschwindigkeiten vergleichsweise moderat sind. Dabei beträgt die Fluidgeschwindigkeit zwischen 1 und 3 m/s, als vorteilhaft hat sich dabei insbesondere eine Fluidgeschwindigkeit von 2,2 m/s erwiesen.

Der Druckabfall wird erfindungsgemäß nicht durch eine Querschnittsverengung und hohe Kanallänge generiert, sondern durch Änderung der Fließrichtung und einer hochturbulenten Strömung mit hohem Wärmeübergangsvermögen.

Wenn mehrere Komponenten gekühlt werden müssen, können die Module so aneinandergereiht werden, dass das Fluid in mehreren Wechselzügen die Komponenten nacheinander entwärmt, um eine gleichmäßige Kühlung zu erzielen.

Erfindungsgemäß stellt sich also zwischen unterschiedlichen Bereichen eines erfindungsgemäßen modularen Kühlkörpers ein geringer Temperaturgradient ein, so dass sich eine über den gesamten Kühlkörper betrachtet gleichmäßige Kühlwirkung einstellt.

Durch den vergleichsweise geringen Abstand der einzelnen Windungen der Kühlkanäle ergibt sich über den gesamten Kühlkörper hinweg eine thermische Vergleichmäßigung, so dass sich innerhalb des Kühlkörpers und den zu kühlenden Komponenten ein vergleichsweise geringer Temperaturgradient einstellt.

Im Idealfall entspricht bei einem Modul oder dem gesamten Kühlkörper zumindest abschnittsweise der Abstand zweier benachbarter Kühlkanäle der Kanalbreite, was die thermische Vergleichmäßigung innerhalb des Kühlkörpers unterstützt.

Erfindungsgemäß wird der Druckabfall in den Kanälen des Kühlkörpers durch eine gezielte Umlenkung der Fließrichtung des Fluids erzeugt, die Fluidgeschwindigkeit bleibt moderat. Vorteilhafterweise führt dies zu einer vergleichsweise besseren turbulenten Verwirbelung des Kühlmediums im Kühlkanal, damit zu einer turbulenten Grenzschicht und damit zu einer höheren Wärmeübergangszahl. Diese Faktoren führen zu einer besseren Kühlleistung.

Unterschiedlich ist der Aufbau des Kühlkanals. Bei den bekannten Lösungen wird der Kanal nicht modular aufgebaut.

Bei der Erfindung besteht der Kühlkörper/Kühlkanal aus mehreren Modulen, die in unterschiedlichen Richtungen miteinander, beispielsweise über Muffen, verbunden werden können. Damit ist ein Kühlkörper in einfacher Art und Weise mit nahezu gleichartigen Modulen skalierbar und damit u.a. einfach erweiterbar.

Der Vorteil ist eine gleichmäßigere Kühlung der zu kühlenden Fläche und eine Erhöhung der Wärmeleistung.

Vorteilhaft ist auch, dass durch die Modularisierung Kühlkörper mit unterschiedlich großen Kühlflächen, lediglich durch unterschiedliche Anzahl und Verbindung von gleichen Modulen, konzipiert, konstruiert und thermisch ausgelegt werden können.

Vorteilhaft ist auch, dass nur durch Skalierung von einem Modul, z. B. durch Änderung der Kanaltiefe, unterschiedliche Druckabfälle erzeugt werden können, ohne die Form des Modules zu ändern.

Die Erfindung sowie weitere vorteilhafte Ausgestaltungen der Erfindung werden anhand prinzipiell dargestellter Ausführungsbeispiele näher erläutert, darin zeigen:
- FIG 1: Kühlkanal ohne Kühlkörper,
- FIG 2: Kühlkörper mit Kanal,
- FIG 3: Kühlkörper mit Kühlkanal und zu kühlenden elektronischen Komponenten,
- FIG 4: Schnitt durch Kühlkörper,
- FIG 5: perspektivische Darstellung des Kühlkörpers.

Es sei angemerkt, dass sich Begriffe wie "axial", "radial", "tangential" etc. auf die in der jeweiligen Figur bzw. im jeweils beschriebenen Beispiel zum Einsatz kommende Achse beziehen. Mit anderen Worten beziehen sich die Richtungen axial, radial, tangential stets auf eine Achse. Dabei beschreibt "axial" eine Richtung parallel zur Achse, "radial" beschreibt eine Richtung orthogonal zur Achse, auf diese zu oder auch von ihr weg, und "tangential" ist eine Richtung, die in konstantem radialem Abstand zur Achse und bei konstanter Axialposition kreisförmig um die Achse herum gerichtet ist. Der Ausdruck "in Umfangsrichtung" ist mit "tangential" gleichzusetzen.

In Bezug auf eine Fläche, bspw. eine Querschnittsfläche, beschreiben die Begriffe "axial", "radial", "tangential" etc. die Orientierung des Normalenvektors der Fläche, d.h. desjenigen Vektors, der senkrecht auf der betroffenen Fläche steht.

Der Begriff "komplementär" meint im Zusammenhang mit zwei Komponenten, welche "komplementär" zueinander sind, dass ihre äußeren Formen derart ausgestaltet sind, dass die eine Komponente vorzugsweise vollständig in der zu ihr komplementären Komponente angeordnet werden kann, so dass sich die innere Oberfläche der einen Komponente und die äußere Oberfläche der anderen Komponente idealerweise lückenlos bzw. vollflächig berühren. Konsequenterweise ist also im Falle von zwei zueinander komplementären Gegenständen die äußere Form des einen Gegenstandes durch die äußere Form des anderen Gegenstandes festgelegt. Der Begriff "komplementär" könnte durch den Begriff "invers" ersetzt werden.

Der Übersichtlichkeit wegen werden in den Figuren teilweise in den Fällen, in denen Bauteile mehrfach vorhanden sind, häufig nicht sämtliche dargestellten Bauteile mit Bezugszeichen versehen.

Die beschriebenen Ausführungen können beliebig kombiniert werden. Ebenso sind auch Einzelmerkmale der jeweiligen Ausführungen kombinierbar, ohne das Wesen der Erfindung zu verlassen.

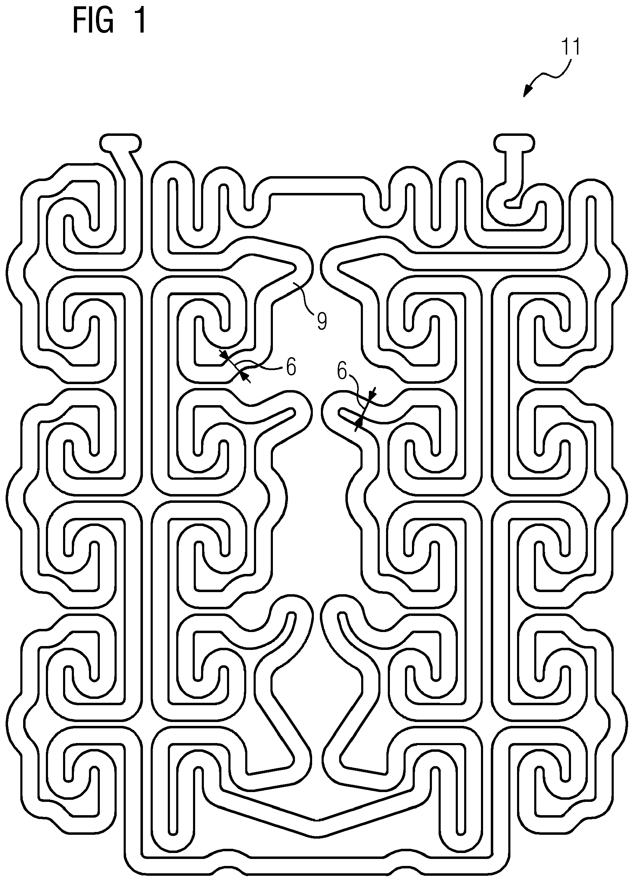

FIG 1 zeigt einen Verlauf eines Kühlkanals 9 eines modular aufgebauten Kühlkörper, insbesondere Flüssigkeits-Kühlkörper (1). Der Verlauf des Kühlkanals 9 bildet eine modifizierte raumfüllende Kurve, wie sie z. B. als Hilbert- oder Peano-Kurven bekannt sind.

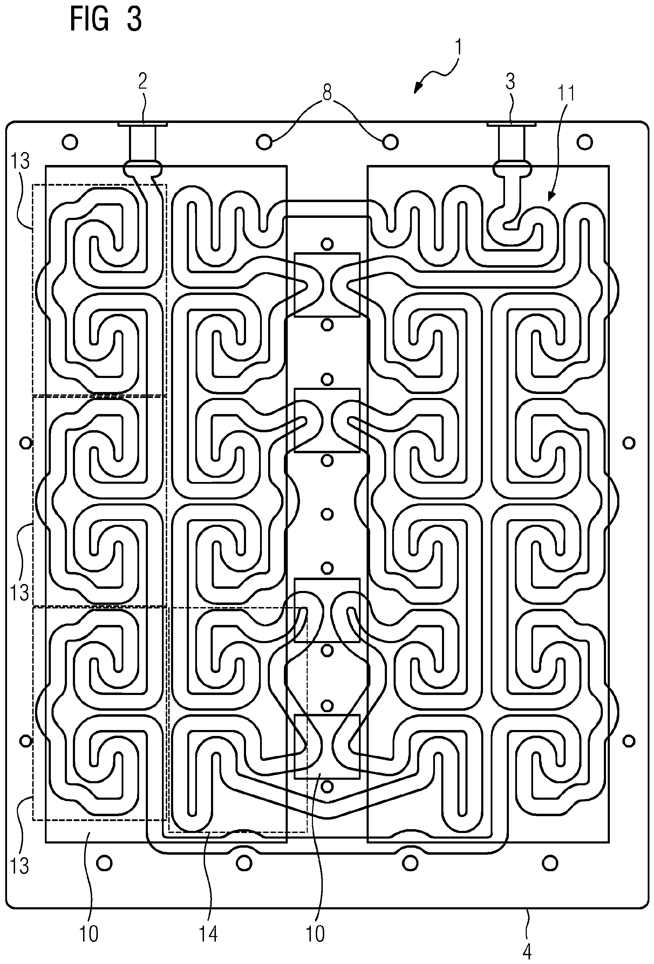

Ein Druckabfall wird durch Umlenkung der Fließrichtung eines Kühlmediums, wie Flüssigkeit oder Gas erzeugt, was eine zusätzliche Durchmischung der Fluidschichten des Kühlmediums bewirkt, und zu einer turbulenten Grenzschicht führt. Dies führt erfindungsgemäß zu einer höheren Wärmeübergangszahl zwischen einem Kühlkörper 1 und einer Komponente, wie z.B. Leistungshalbleiter 10. Damit ergibt sich eine vergleichsweise bessere thermische Performance des gesamten Kühlsystems. Der Kühlkanal 9 deckt nahezu die gesamte zu kühlende Fläche ab, wie dies beispielsweise auch FIG 3 zu entnehmen ist. Die Anordnung der Kühlkanäle der Module 13, 14 und/oder des Kühlkörpers 1 verläuft dabei insbesondere in einer Ebene.

Durch den vergleichsweise geringen Abstand der einzelnen Windungen der Kanalstruktur 11 der Kühlkanäle 9 ergibt sich über den gesamten Kühlkörper 1 hinweg eine thermische Vergleichmäßigung, so dass innerhalb des Kühlkörpers 1 und den zu kühlenden Komponenten ein vergleichsweise geringer Temperaturgradient bei gleichmäßiger Kühlleistung vorhanden ist.

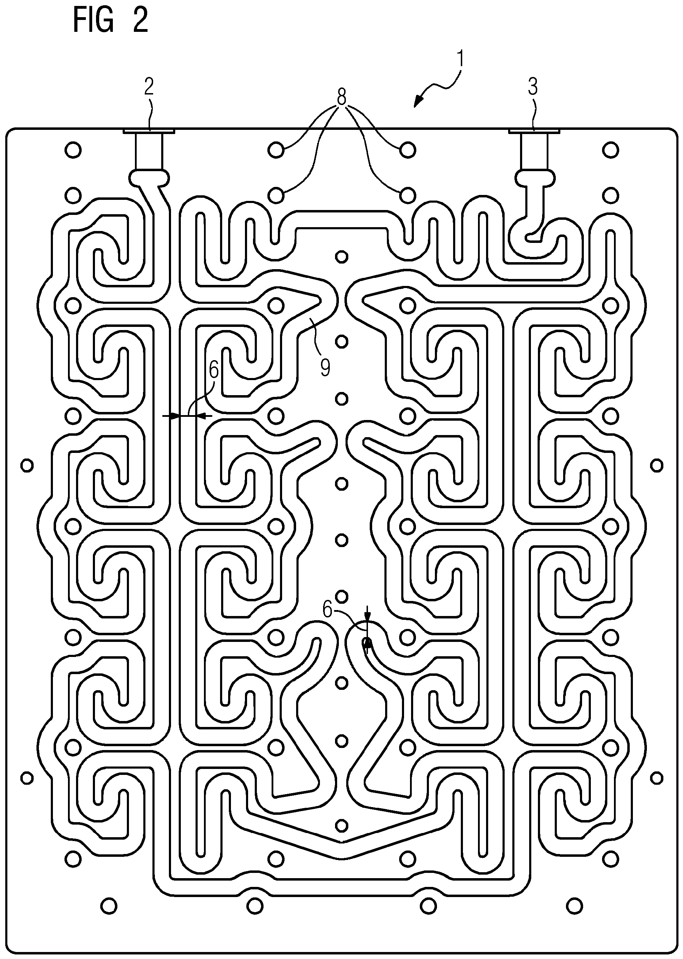

FIG 2 zeigt einen Kühlkörper 1 mit dem Verlauf des Kühlkanals 9 und dessen Einlass 2 und Auslass 3. Über Befestigungspunkte 8 sind vorzugsweise die Teile eines Gehäuses 4 des Kühlkörpers 1 fixierbar. Ebenso können über diese Befestigungspunkte 8 auch die Leistungshalbleiterkomponenten 10 fixiert werden.

FIG 3 zeigt den Kühlkörper 1 mit den von der Kanalstruktur 11 beaufschlagten Bereiche, die mit zu kühlenden Leistungshalbleiterkomponenten 10 versehen sind. Ebenso sind die beispielhaft aufgezeigten Module 13, 14 skizziert, mit denen ein nahezu beliebiger Kühlkörper 1 gestaltbar ist. Modul 13 zeigt dabei einen Kühlkanal, der ähnlich einer Hilbert- oder Peano-Kurve aufgebaut ist und einen bestimmten Druckabfall aufweist. Modul 14 ist beispielsweise ein modifiziertes Modul 13 (z.B. um 180° gedreht), das für andere zu kühlende Komponenten verlängert/angepasst ist. Der Druckabfall entspricht dabei im Wesentlichen Modul 13.

Der Druckabfall im Kühlkörper 1 oder in den Modulen 13, 14 wird durch die Umlenkung des Kühlfluids im Kühlkanal 9 erzeugt und nicht durch eine Querschnittsverengung des Kanals oder die Kanallänge. Der Gesamtdruckabfall im Kühlkörper 1 ist somit die Summe der Druckabfälle aller - vorzugsweise in Reihe geschalteten - Module 13,14, was den Kühlkörper 1 modular und skalierbar gestaltet.

Der Druckabfall eines einzelnen Moduls 13, 14 ist bei der Herstellung über die Form und/oder den Querschnitt seines Kühlkanals 9 einstellbar. Sofern ein Kühlkörper 1 mehrere Module 13, 14 aufweist, sind diese über nicht näher dargestellte Muffen fluidtechnisch koppelbar.

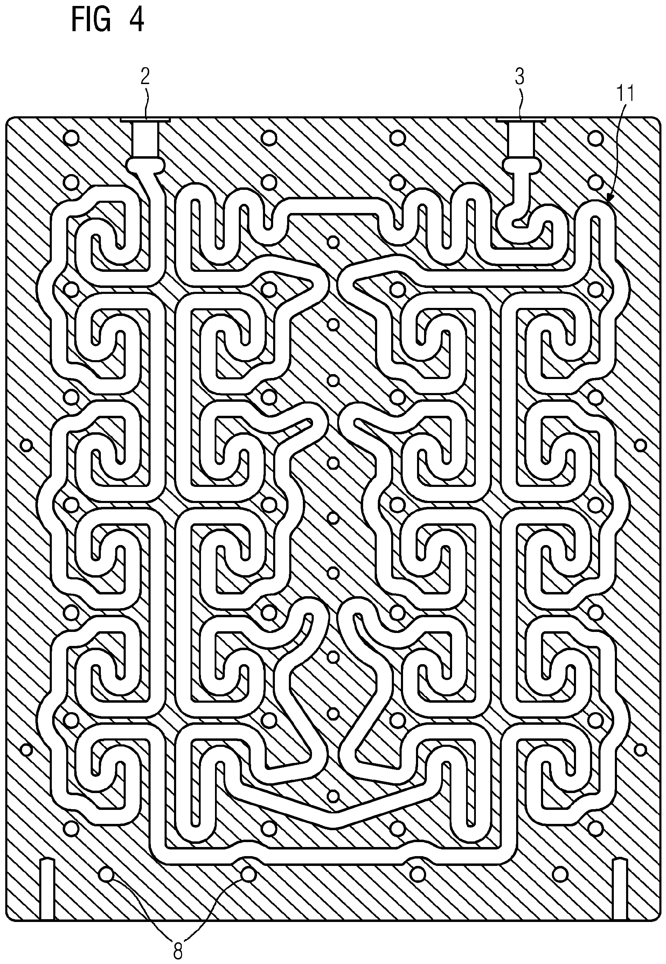

FIG 4 zeigt besonders vorteilhaft die modulartige Kanalstruktur 11 des Kühlkörpers 1, die erfindungsgemäß skalierbar einfach erweiterbar ist. Dabei werden die Module 13, 14 je nach Bedarf zusammengesetzt. Der Kühlkörper 1 ist dabei ein gut wärmeleitendes Material, in das die Kanalstruktur 11 eingebettet ist. Diese Kanalstruktur 11 des gesamten Kühlkörpers 1 oder der einzelnen Module 13, 14 wurde beispielsweise in einen Materialblock eingefräst. Ebenso ist es möglich, den Kühlkörper 1 mit dieser Kanalstruktur 11 in 3-D zu drucken.

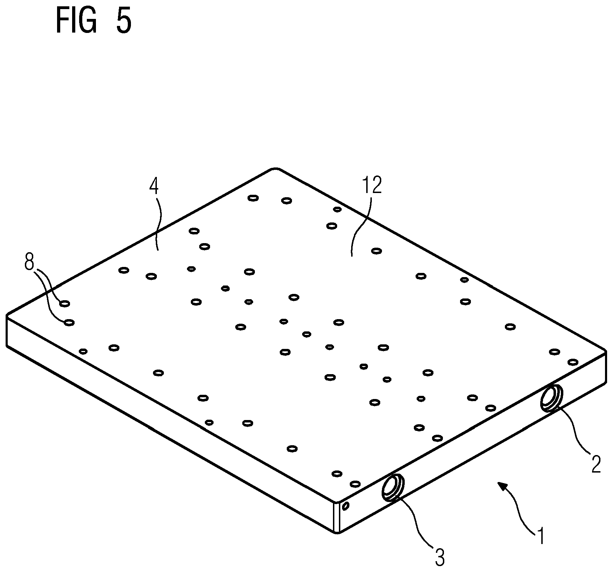

FIG 5 zeigt in perspektivischer Darstellung einen Kühlkörper 1 mit den Befestigungspunkten 8, an denen die Leistungshalbleiterkomponenten 10 befestigt werden können. Vorteilhafterweise ist zwischen Kühlkörper 1 und den Leistungshalbleiterkomponenten 10 eine Wärmeleitpaste vorgesehen, um die thermische Kopplung zu verbessern.

### Bezugszeichenliste

- 1: Kühlkörper
- 2: Einlass
- 3: Auslass
- 4: Gehäuse
- 6: Breite des Kühlkanals
- 7: zu kühlende Komponente
- 8: Befestigungspunkte
- 9: Kühlkanal
- 10: Leistungshalbleiterkomponente
- 11: Kanalstruktur
- 12: Deckel
- 13, 14: Module

## Patentansprüche

1. Modular aufgebauter Kühlkörper, insbesondere Flüssigkeits-Kühlkörper (1) eines Leistungshalbleiters (10),
wobei der Flüssigkeits-Kühlkörper (1) zumindest einen Einlass (2) und einen Auslass (3) in einem Gehäuse (4) aufweist, das den Flüssigkeits-Kühlkörper (1) umgibt und an den die Leistungshalbleiter (10) zumindest auf einer Seite des Gehäuses (4) thermisch direkt gekoppelt sind,
wobei eine offene Kanalstruktur (11) in einem wärmeleitenden Material vorgesehen ist, das durch einen Deckel des Gehäuses (4) geschlossen ist,
wobei die Kanalstruktur (11) des Flüssigkeits-Kühlkörpers (1) ist als eine modifizierte raumfüllende Kurve ausgeführt.

2. Modular aufgebauter Kühlkörper, insbesondere Flüssigkeits-Kühlkörper (1) nach Anspruch 1, **dadurch gekenn-zeichnet,** dass die Form der Kanalstruktur (11) in ihrer Länge modular aufgebaut ist.

3. Modular aufgebauter Kühlkörper, insbesondere Flüssigkeits-Kühlkörper (1) nach Anspruch 1 oder 2, **dadurch gekennzeichnet, dass** im Verlauf des Kühlkanals (9) eines Moduls und/oder des Flüssigkeits-Kühlkörpers (1) gleiche Kanalbreite (6) vorgesehen ist.

4. Modular aufgebauter Kühlkörper, insbesondere Flüssigkeits-Kühlkörper (1) nach einem der vorhergehenden Ansprüche, **dadurch gekennzeichnet, dass** zumindest abschnittsweise unterschiedliche Kanaltiefen innerhalb des Kühlkörpers, insbesondere Flüssigkeits-Kühlkörpers (1) bei Beibehaltung der Kanalstruktur (11) vorgesehen sind.

5. Umrichter eines elektrischen Antriebs, der zumindest einen modular aufgebauten Kühlkörper, insbesondere Flüssigkeits-Kühlkörper (1) nach zumindest einem der vorhergehenden Ansprüche aufweist.
